(19) Europäisches Patentamt
European Patent Office
Office européen des brevets

(11) Veröffentlichungsnummer: **0 006 561**
**B1**

(12) # EUROPÄISCHE PATENTSCHRIFT

(45) Veröffentlichungstag der Patentschrift: **16.02.83**

(51) Int. Cl.³: **G 03 F 7/08**, C 07 C 143/68

(21) Anmeldenummer: **79101994.6**

(22) Anmeldetag: **18.06.79**

(54) **Lichtempfindliches Gemisch.**

(30) Priorität: **26.06.78 DE 2828037**

(43) Veröffentlichungstag der Anmeldung:
**09.01.80 Patentblatt 80/1**

(45) Bekanntmachung des Hinweises auf die Patenterteilung:
**16.02.83 Patentblatt 83/7**

(84) Benannte Vertragsstaaten:
**AT BE CH DE FR GB IT NL SE**

(56) Entgegenhaltungen:
**DE - C - 872 154**
**FR - A - 1 260 028**
**US - A - 3 046 118**
**US - A - 3 669 658**

(73) Patentinhaber: **HOECHST AKTIENGESELLSCHAFT**
**Postfach 80 03 20**
**D-6230 Frankfurt/Main 80 (DE)**

(72) Erfinder: **Buhr, Gerhard, Dr.**
**Am Erdbeerstein 28**
**D-6240 Königstein (DE)**
Erfinder: **Ruckert, Hans, Dr.**
**Erbsenacker 21**
**D-6200 Wiesbaden-Naurod (DE)**

**EP 0 006 561 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Courier Press, Leamington Spa, England.

# Lichtempfindliches Gemisch

Die Erfindung betrifft ein positiv arbeitendes lichtempfindliches Gemisch, das ein wasserunlösliches, in wäßrig-alkalischen Lösungen lösliches oder quellbares harzartiges Bindemittel und einen Bis-1,2-naphthochinon-2-diazid-sulfonsäureester eines 4,4'-Dihydroxy-diphenylmethanderivats enthält.

Es ist bereits eine große Anzahl von Derivaten, insbesondere Estern, von 1,2-Naphthochinon-2-diazid-sulfonsäuren bekannt, die als lichtempfindliche Verbindungen in positiv arbeitenden Kopiermaterialien verwendbar sind. Das Buch von Jaromir Kosar: "Light-Sensitive Systems", John Wiley & Sons/New York, 1965, nennt auf den Seiten 343—351 eine Reihe lichtempfindlicher Naphthochinondiazide, die DE—PS 938 233, 1 118 606, 1 120 273 und die DE—OS 1 904 764 beschreiben insbesondere für die Herstellung von positiv arbeitenden Druckplatten geeignete derartige Verbindungen. Von diesen Verbindungen werden in neuerer Zeit diejenigen bevorzugt, die keine freien OH-Gruppen aufweisen, da sie höhere Druckauflagen und höhere Entwicklerresistenzen ergeben. Auch werden zur Erzielung hoher Druckauflagen meist Verbindungen mit mehr als einer o-Naphthochinondiazid-sulfonsäureestergruppe im Molekül bevorzugt. Zu diesen Verbindungen gehört z. B. der Bis-(1,2-naphthochinon-2-diazid-5-sulfonsäure)-ester des 2,2-Bis-(4-hydroxyphenyl)-propans, der in der DE—PS 872 154 beschrieben ist. Ähnliche Verbindungen sind auch in der veröffentlichten europäischen Patentanmeldung Nr. 1254 beschrieben. Trotz der hervorragenden kopier- und drucktechnischen Eigenschaften, welche diese Verbindungen in Kopiermaterialien bewirken, steht ihrer breiteren technischen Anwendung, ebenso wie bei anderen Vertretern dieser Gruppe, eine relativ geringe Löslichkeit in organischen Lösungsmitteln entgegen. Die Herstellung von konzentrierteren Lösungen, wie sie bei der maschinellen Beschichtung von Aluminiumband oder zur Bereitung von Kopierlacken erforderlich sind, ist erschwert.

Man hat diesen Nachteil bereits erkannt und in den technischen Patentschriften 160 783 und 160 784 durch die Verwendung des Mono-1,2-naphtochinon-2-diazid-5-sulfonsäureesters des 2,2-Bis-(4-hydroxyphenyl)-propans zu überwinden versucht. Bei der Kondensation des Bisphenols mit dem 1,2-Naphthochinon-2-diazid-5-sulfonsäurechlorid ist die Bildung des Bis-sulfonsäureesters jedoch nicht zu vermeiden. Es fallen Gemische an. Lösungen dieser Gemische in organischen Lösungsmitteln können Veränderungen unterworfen sein, indem schwerer lösliche Bestandteile auskristallisieren und so die Beschichtung von Druckplatten und Leiterplatten stören. Mono-1,2-naphthochinondiazid-sulfonsäureester beeinträchtigen zudem, wie erwähnt, häufig die Höhe der Druckauflage damit hergestellter Offset-Druckplatten und bewirken ungenügende Entwicklerresistenz.

Aufgabe der Erfindung war es, ein lichtempfindliches, positiv arbeitendes Gemisch mit neuen 1,2-Naphthochinon-2-diazid-sulfonsäureestern als lichtempfindliche Verbindungen vorzuschlagen, das in seinen druck- und kopiertechnischen Eigenschaften mit den besten bisher bekannten Gemischen dieser Art mindestens vergleichbar ist, dessen lichtempfindliche Verbindungen sich aber zusätzlich durch eine höhere Löslichkeit in organischen Lösungsmitteln auszeichnen und sich in einfacher Weise in chemisch einheitlicher Form herstellen lassen.

Die Erfindung geht aus von einem lichtempfindlichen Gemisch, das ein wasserunlösliches, in wäßrig-alkalischen Lösungen lösliches oder mindestens quellbares harzartiges Bindemittel und einen Bis-1,2-naphthochinon-2-diazid-sulfonsäureester eines 4,4'-Dihydroxy-diphenylmethanderivats enthält.

Die Aufgabe wird dadurch gelöst, daß der Ester der Formel I

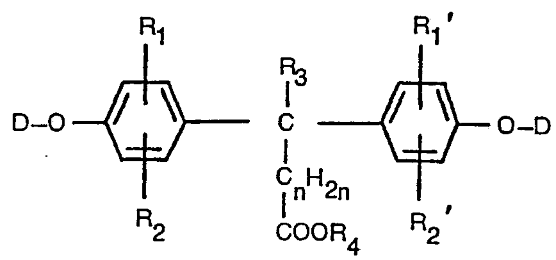

(I)

entspricht, worin

$R_1$, $R_1'$, $R_2$ und $R_2'$ gleich oder verschieden sind und Wasserstoff-, Chlor- oder Bromatome, Alkyl-, Alkoxy- oder Alkoxyalkylreste mit 1 bis 6 Kohlenstoffatomen oder Alkenylreste mit 2 bis 6 Kohlenstoffatomen,

$R_3$ ein Wasserstoffatom oder einen Alkylrest mit 1 bis 4 Kohlenstoffatomen,

$R_4$ ein Wasserstoffatom, einen ggf. substituierten Alkylrest, dessen Kohlenstoffkette durch Äthersauerstoffatome unterbrochen sein kann, einen gegebenenfalls substituierten Cycloalkylrest mit 5

bis 16 Kohlenstoffatomen oder einen ggf. substituierten Alkenylrest mit 2 bis 16 Kohlenstoffatomen,
n Null oder eine ganze Zahl von 1 bis 4 und
D einen 1,2-Naphthochinon-2-diazid-sulfonylrest
bedeuten.

Die in dem erfindungsgemäßen Gemisch enthaltenen Naphthochinondiazid-Verbindungen sind neu. Hergestellt werden sie nach bekannten Verfahren durch Veresterung des entsprechenden Bisphenols mit reaktiven Naphthochinondiazidsulfonsäurederivaten, z. B. dem Säurechlorid. Als bevorzugte Verfahren kommen die Umsetzungen in inerten Lösungsmitteln, wie Ketonen, Estern oder chlorierten Kohlenwasserstoffen, in Gegenwart tertiärer Amine, wie Pyridin, Dimethylanilin oder Triäthylamin, in Betracht. Die Naphthochinondiazidsulfonsäureester können jedoch auch in organischwäßrigen Lösungen, z. B. in Gemischen von Dioxan oder Aceton und wäßriger Sodalösung bzw. Natriumhydrogencarbonatlösung, dargestellt werden.

Die Bisphenolkomponenten, d. h. die Bisphenolcarbonsäuren und ihre Ester, sind durch Kondensation von Phenol oder entsprechend substituierten Phenolen mit Ketocarbonsäuren bzw. deren Estern erhältlich, wie es z. B. im Journ. Org. Chem *23*, 1004 (1958), in der DE—AS 1 093 377 oder in der DE—PS 1 953 332 beschrieben ist. Als Katalysatoren werden saure Agenzien, z. B. Schwefelsäure oder konzentrierte Salzsäure, allein oder mit Cokatalysatoren, ggf. im Gemisch mit Essigsäure, verwendet. Die Veresterung der freien Carbonsäuren erfolgt nach bekannten Verfahren, normalerweise sauer katalysiert in einem Überschuß des zu veresternden Alkohols oder unter azeotroper Entfernung des Reaktionswassers in Gegenwart eines Schleppmittels, z. B. von Benzol, Toluol oder Methylenchlorid.

Die Reste $R_1$, $R_1'$, $R_2$ und $R_2'$ in den Benzolkernen des Bisphenols sind vorzugsweise Wasserstoffatome oder Methylgruppen. Wenn diese Reste von Wasserstoff verschiedene Substituenten sind, stehen sie bevorzugt in der 3- oder der 3- und 5-Stellung der 4-Hydroxy-phenylgruppen. Der Rest $R_3$ ist vorzugsweise eine Methylgruppe, n bedeutet vorzugsweise eine Zahl von 1 bis 3, wobei die Gruppe $C_nH_{2n}$ bevorzugt unverzweigt ist. Ebenfalls bevorzugt werden Verbindungen, in denen $R_3$ ein Wasserstoffatom und n Null ist.

$R_4$ ist vorzugsweise ein gesättigter geradkettiger oder verzweigter Alkylrest, der bis zu vier Äthergruppen und 1 bis 8 Kohlenstoffatome enthält.

Der Sulfonsäurerest der 1,2-Naphthochinondiazidderivate steht im allgemeinen in der 4- oder 5-Stellung des Naphthochinondiazids, die 5-Sulfonsäureester werden bevorzugt. Als Ketocarbonsäuren sind bevorzugt die Glyoxylsäure, die Acetessigsäure und die Lävulinsäure zu nennen, als Hydroxyarylreste 4-Hydroxyphenyl-, 4-Hydroxy-3-methyl-phenyl- und 4-Hydroxy-3,5-dimethyl-phenylgruppen.

Neben den in den Beispielen genannten Verbindungen können z. B. die Bis-1,2-naphthochinondiazid-4- und insbesondere -5-sulfonsäureester der folgenden Bisphenolderivate eingesetzt werden:

2,2-Bis-(4-hydroxy-3-methyl-phenyl)-essigsäureäthylester, -butylester und -äthoxy-äthylester,
2,2-Bis-(4-hydroxy-phenyl)-propionsäure-methylester und -äthylester,
3,3-Bis-(4-hydroxy-phenyl)-buttersäure-methylester, -äthylester, -hexylester, -2-äthoxy-äthylester, -2-butoxy-äthylester,
3,3-Bis-(4-hydroxy-3-methyl-phenyl)-buttersäure-äthylester, -isopropylester, -2-methoxy-äthylester, -isobutylester, -cyclohexylester,
3,3-Bis-(4-hydroxy-3,5-dimethyl-phenyl)-buttersäure-methylester, -äthylester, -dodecylester, -benzylester, -allylester,
3,3-Bis-(3-allyl-4-hydroxy-phenyl)-buttersäure-äthylester,
4,4-Bis-(4-hydroxy-phenyl)-buttersäure-methylester, -äthylester, -n-propylester, -2-äthoxy-äthylester, -isobutylester, -n-decylester,
4,4-Bis-(4-hydroxy-3-methyl-phenyl)-buttersäure-methylester, -3-methoxy-butylester, -2-äthyl-hexylester, -octylester,
2,2-Bis-(4-hydroxy-phenyl)-valeriansäure-2-hydroxy-äthylester und -6-chlor-hexylester,
4,4-Bis-(4-hydroxy-2-methoxy-phenyl)-valeriansäure-methylester, -butylester,
4,4-Bis-(4-hydroxy-3-methyl-phenyl)-valeriansäure-methylester, -äthylester, -isooctylester,
4,4-Bis-(4-hydroxy-3,5-dimethyl-phenyl)-valeriansäure-methylester, -äthylester, -2-äthoxy-äthylester,
4,4-Bis-(3-chlor-4-hydroxy-phenyl)-valeriansäure-methylester, -äthylester, -n-propylester,
4,4-Bis-(4-hydroxy-phenyl)-hexansäure-methylester, -äthylester,
4,4-Bis-(4-hydroxy-3-methyl-phenyl)-hexansäure-äthylester, -2-methoxy-äthylester,
5,5-Bis-(4-hydroxy-phenyl)-hexansäure-methylester, -äthylester, -2-äthoxy-äthylester und
5,5-Bis-(4-hydroxy-3-methyl-phenyl)-hexansäure-methylester, -n-propylester und -2-(2-methoxy-äthoxy)-äthylester,
6,6-Bis-(4-hydroxy-3-methyl-phenyl)-heptansäure-methylester, -äthylester,
5,5-Bis-(4-hydroxy-3,5-dimethyl-phenyl)-heptansäure-methylester, -äthylester,
4,4-Bis-(4-hydroxy-phenyl)-octansäure-methylester, -äthylester,
6,6-Bis-(4-hydroxy-3-methyl-phenyl)-octansäure-methylester und -äthylester.

Bisphenolcarbonsäure-Derivate mit stärker raumerfüllenden Substituenten in 3-Stellung des Hydroxyarylrestes lassen sich ebenfalls, wenn auch in langsamerer Reaktion und schlechterer Ausbeute mit Naphthochinondiazidsulfonsäurechlorid umsetzen, wie am Beispiel des Bis-1,2-naphthochinondiazid-5-sulfonsäureesters des 3,3-Bis-(3-tert-butyl-4-hydroxy-phenyl)-buttersäuremethylesters gezeigt werden konnte.

Die Konzentration der neuen Naphthochinondiazidsulfonsäureester in der lichtempfindlichen Schicht kann in relativ weiten Grenzen schwanken. Im allgemeinen liegt der Anteil bei 3 bis 50%, vorzugsweise zwischen 7 und 35%, bezogen auf das Gewicht des Feststoffanteils des lichtempfindlichen Gemischs. Gegebenenfalls kann im Rahmen dieser Mengen auch ein Teil der neuen Naphthochinondiazidderivate durch eine entsprechende Menge eines bekannten Naphthochinondiazids ersetzt werden, doch sollte bevorzugt der Mengenanteil der neuen Verbindung überwiegen.

Die erfindungsgemäßen lichtempfindlichen Gemische enthalten ferner ein polymeres, wasserunlösliches harzartiges Bindemittel, das sich in den für das erfindungsgemäße Gemisch verwendeten Lösungsmitteln löst und in wäßrigen Alkalien ebenfalls löslich oder zumindest quellbar ist.

Die bei vielen Positiv-Kopiermaterialien auf Basis von Naphthochinondiaziden bewährten Novolak-Kondensationsharze haben sich als Zusatz auch bei den erfindungsgemäßen Gemischen mit den neuen Naphthochinondiazidsulfonsäureestern als besonders brauchbar und vorteilhaft erwiesen. Sie fördern die starke Differenzierung zwischen den belichteten und unbelichteten Schichtpartien beim Entwickeln, besonders die höher kondensierten Harze mit substituierten Phenolen, z. B. Kresolen, als Formaldehyd-Kondensationspartner. Die Art und Menge der Novolak-Harze kann je nach Anwendungszweck verschieden sein; bevorzugt sind Novolak-Anteile am Gesamtfeststoff zwischen 95 und 50, besonders bevorzugt 90—65 Gew.-%. Zusätzlich können noch zahlreiche andere Harze mitverwendet werden, bevorzugt Vinylpolymerisate wie Polyvinylacetate, Polyacrylate, Polyvinyläther, Polyvinylpyrrolidone und die Mischpolymerisate der ihnen zugrundeliegenden Monomeren. Der günstigste Anteil an diesen Harzen richtet sich nach den anwendungstechnischen Erfordernissen und dem Einfluß auf die Entwicklungsbedingungen und beträgt im allgemeinen nicht mehr als 20 Gew.-% vom alkalilöslichen Harz. Im geringen Mengen kann das lichtempfindliche Gemisch für spezielle Erfordernisse wie Flexibilität, Haftung, Glanz, Färbung und Farbumschlag etc. außerdem noch Substanzen wie Polyglykole, Cellulose-Derivate wie Äthylcellulose, Netzmittel, Farbstoffe, Haftvermittler und feinteilige Pigmente sowie bei Bedarf UV-Absorber enthalten. Als weitere alkalilösliche bzw. in Alkali quellbare Bindemittel sind natürliche Harze wie Schellack und Kolophonium und synthetische Harze wie z. B. Mischpolymerisate aus Styrol und Maleinsäureanhydrid oder Mischpolymerisate der Acrylsäure oder Methacrylsäure, insbesonder mit Acryl- oder Methacrylsäureestern, zu nennen.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methyläthylketon, chlorierte Kohlenwasserstoffe wie Trichloräthylen und 1,1,1-Trichloräthan, Alkohole wie n-Propanol, Äther wie Tetrahydrofuran, Alkoholäther wie Äthylenglykol-monoäthyläther und Ester wie Butylacetat. Es können auch Gemische verwendet werden, die zudem noch für spezielle Zwecke Lösungsmittel wie Acetonitril, Dioxan oder Dimethylformamid enthalten können. Prinzipiell sind alle Lösungsmittel verwendbar, die mit den Schichtkomponenten nicht irreversibel reagieren.

Als Schichtträger für Schichtdicken unter ca. 10 $\mu$m werden meist Metalle verwendet. Für Offsetdruckplatten können eingesetzt werden: walzblankes, mechanisch oder elektrochemisch aufgerauhtes und ggf. anodisiertes Aluminium, das zudem noch chemisch, z. B. mit Polyvinylphosphonsäure, Silikaten oder Phosphaten, vorbehandelt sein kann, außerdem Mehrmetallplatten mit Cu/Cr oder Messing/Cr als oberster Schicht. Für die Herstellung von Hochdruckplatten können die erfindungsgemäßen Gemische auf Zink- oder Magnesium-Platten sowie deren handelsübliche mikrokristalline Legierungen für Einstufenätzverfahren aufgetragen werden, außerdem auf ätzbare Kunststoffe wie Polyoxymethylen. Für Tiefdruck- oder Siebdruckformen eignen sich die erfindungsgemäßen Gemische durch ihre gute Haftung und Ätzfestigkeit auf Kupfer- und Nickel-Oberflächen. Ebenso lassen sich die erfindungsgemäßen Gemische als Photoresists in der Leiterplattenfertigung und beim Formteilätzen verwenden.

Für weitere Anwendungen kommen auch andere Träger wie Holz, Papier, Keramik, Textil und andere metalle in Betracht.

Bevorzugte Träger für dicke Schichten über 10 $\mu$m sind Kunststoff-Folien, die dann als temporäre Träger für Transferschichten dienen. Dafür und für Farbprüffolien werden Polyesterfolien, z. B. aus Polyäthylenterephthalat, bevorzugt. Polyolefinfolien wie Polypropylen sind jedoch ebenfalls geeignet.

Die Beschichtung des Trägermaterials erfolgt in bekannter Weise durch Aufschleudern, Sprühen, Tauchen, Walzen, mittels Breitschlitzdüsen, Rakeln oder durch Gießer-Antrag. Schließlich kann die Beschichtung von z. B. Leiterplatten, Glas oder Keramik und Silizium-Scheiben auch durch Schichtübertragung von einem temporären Träger erfolgen.

Belichtet wird mit den in der Technik üblichen Lichtquellen. Auch das Bestrahlen mit Elektronen stellt eine Möglichkeit zur Bebilderung dar.

Die zum Entwickeln verwendeten wäßrig-alkalischen Lösungen abgestufter Alkalität, die auch

kleinere Mengen organischer Lösungs- oder Netzmittel enthalten können, entfernen die vom Licht getroffenen Stellen der Kopierschicht und erzeugen so ein positives Abbild der Vorlage.

Bevorzugte Anwendung finden die erfindungsgemäßen lichtempfindlichen Gemische bei der Herstellung von Druckformen, d. h. insbesondere Offset-, autotypischen Tiefdruck- und Siebdruckformen, in Kopierlacken und sogenannten Trockenresists.

Die unter Verwendung der neuen Verbindungen hergestellten Druckplatten besitzen eine hohe praktische Lichtempfindlichkeit sowie eine verbesserte Resistenz gegenüber alkalischen Entwicklern. Die bevorzugten Verbindungen selbst zeichnen sich durch eine gute bis hervorragende Löslichkeit in den üblichen organischen Lösungsmitteln sowie durch eine gute Verträglichkeit mit den Bestandteilen der Kopierschicht aus.

Zur weiteren Erhöhung der Widerstandsfähigkeit beim Druck sowie der Resistenz gegen Auswaschmittel, Korrekturmittel und durch UV-Licht härtbare Druckfarben können die entwickelten Platten kurze Zeit auf erhöhte Temperaturen erwärmt werden, wie es aus der britischen Patentschrift 1 154 749 bekannt ist.

Im folgenden werden Beispiele für das erfindungsgemäße Gemisch angegeben. Dabei wird zuerst die Herstellung einer Anzahl neuer Bis-(1,2-naphthochinon-2-diazid-sulfonsäureester) von Bisphenolcarbonsäuren und -carbonsäureestern beschrieben, die in erfindungsgemäßen Gemischen als lichtempfindliche Komponenten erprobt wurden. Die Numerierung der neuen Verbindungen von 1 bis 22 wird in den Anwendungsbeispielen beibehalten. Prozent- und Mengenverhältnisse sind, wenn nicht anders angegeben, in Gewichtseinheiten zu verstehen.

Allgemeine Vorschrift zur Herstellung der in der Tabelle 1 aufgeführten Verbindungen 1 bis 22

0,5 Mol Bisphenolcarbonsäureester und 1,0—1,03 Mol 1,2-Naphthochinon-2-diazid-sulfonsäurechlorid in 1,5 l Aceton werden unter Rühren in 20 Minuten mit 1,05 Mol Triäthylamin versetzt, wobei man die Temperatur durch Kühlung unter 25°C hält. Nach Beendigung des Zutropfens wird noch 1,5 Stunden weitergerührt und

a) falls der Naphthochinon-diazidsulfonsäureester bereits ausgefallen ist, dieser, ggf. nach Verdünnen des Reaktionsansatzes mit Wasser, abgesaugt, mit kaltem Aceton und anschließend mit Wasser gewaschen und der Filterrückstand bei vermindertem Druck oder im Umlufttrockenschrank bei mäßig erhöhter Temperatur getrocknet. Im allgemeinen werden so nach Maßgabe der Dünnschichtchromatographie (Kieselgel, Laufmittel: Cyclohexan/Äthylacetat-Gemische) praktisch reine Bis-sulfonsäureester erhalten. Ggf. können die Produkte aus Lösungsmitteln, wie Aceton, Methyläthylketon, Äthylacetat oder Äthylenglykolmonomethyläther, umkristallisiert werden.

b) Bei im Reaktionsgemisch vollständig löslichen Bisnaphthochinondiazidsulfonsäureestern wird der Ansatz durch Absaugen von ausgefallenem Triäthylammoniumchlorid befreit. Es können so bis zu 90% der eingesetzten Base zurückgewonnen werden. Das Filtrat wird in die zehnfache Menge 4 %iger wäßriger Salzsäure eingerührt, der ausgefallene Bis-sulfonsäureester abfiltriert, mit Wasser säurefrei gewaschen und wie unter a) getrocknet.

Im Falle der Verbindungen 1 und 12 müssen für die vollständige Umsetzung zum Bisester mindestens 1,5 Mol 1,2-Naphthochinon-2-diazid-5-sulfonsäurechlorid und entsprechend mehr Base verwendet werden, die analysenreine Verbindung 16 wurde durch präparative Dünnschichtchromatographie des Rohproduktes erhalten.

Die Brom-Substituenten in der Verbindung 11 werden in den Bisphenolcarbonsäureester in an sich bekannter Weise eingeführt. Zweckmäßig wird die Ausgangsverbindung in Eisessig gelöst und die Lösung bei Raumtemperatur unter Rühren und, wenn erforderlich, unter Kühlung tropfenweise mit der berechneten Menge Brom versetzt.

TABELLE 1

Bis-1,2-naphthochinon-2-diazid-sulfonsäureester der Formel II

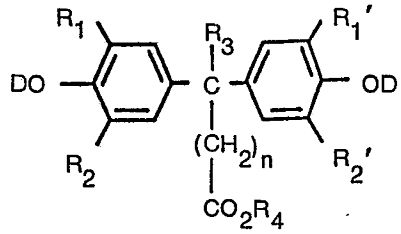

(II)

$R_1 = R_1'$; $R_2 = R_2'$

| Nr. | n | $R_1$ | $R_2$ | $R_3$ | $R_4$ | D | Analyse (%) | |
|---|---|---|---|---|---|---|---|---|
| | | | | | | | $N_{ber.}$ | $N_{gef.}$ |
| 1 | 2 | H | H | $CH_3$ | H | 1) | 7,46 | 7,4 |
| 2 | 2 | H | H | $CH_3$ | $CH_3$ | 1) | 7,33 | 7,2 |
| 3 | 2 | H | H | $CH_3$ | $C_2H_5$ | 1) | 7,19 | 7,0 |
| 4 | 2 | H | H | $CH_3$ | $C_2H_5$ | 2) | 7,19 | 6,9 |
| 5 | 2 | H | H | $CH_3$ | i-$C_3H_7$ | 1) | 7,07 | 7,2 |
| 6 | 2 | H | H | $CH_3$ | n-$C_4H_9$ | 1) | 6,94 | 6,8 |
| 7 | 2 | H | H | $CH_3$ | $CH_3OCH_2CH_2$ | 1) | 6,93 | 7,0 |
| 8 | 2 | H | H | $CH_3$ | $C_2H_5OCH_2CH_2$ | 1) | 6,81 | 6,7 |
| 9 | 2 | H | H | $CH_3$ | $CH_3CH(OCH_3)CH_2CH_2$ | 1) | 6,69 | 6,9 |
| 10 | 2 | H | H | $CH_3$ | $CH_3(CH_2)_{11}$ | 1) | 6,10 | 6,1 |
| 11 | 2 | Br | Br | $CH_3$ | $CH_3$ | 1) | 5,19 | 5,7 |
| 12 | 1 | $CH_3$ | H | $CH_3$ | H | 1) | 7,33 | 6,8 |
| 13 | 1 | $CH_3$ | H | $CH_3$ | $CH_3$ | 1) | 7,19 | 7,1 |
| 14 | 1 | $CH_3$ | H | $CH_3$ | $CH_3(OCH_2CH_2)_3$ | 1) | 6,15 | 6,1 |
| 15 | 1 | $CH_3$ | H | $CH_3$ | $CH_3(CH_2)_9$ | 1) | 6,19 | 6,1 |
| 16 | 1 | t-$C_4H_9$ | H | $CH_3$ | $CH_3$ | 1) | 6,49 | 6,0 |
| 17 | 0 | H | H | H | $CH_3$ | 1) | 7,75 | 7,4 |
| 18 | 0 | H | H | H | $C_2H_5$ | 1) | 7,60 | 7,3 |
| 19 | 0 | H | H | H | n-$C_3H_7$ | 1) | 7,46 | 7,4 |
| 20 | 0 | H | H | H | n-$C_4H_9$ | 1) | 7,33 | 7,3 |
| 21 | 0 | H | H | H | $CH_3OCH_2CH_2$ | 1) | 7,30 | 7,2 |
| 22 | 0 | H | H | H | $C_2H_5OCH_2CH_2$ | 1) | 7,18 | 7,1 |

1) 1,2-Naphthochinon-2-diazid-5-sulfonyl

2) 1,2-Naphthochinon-2-diazid-4-sulfonyl

Die Löslichkeit der neuen Naphthochinondiazide im Vergleich zum bekannten Bis-1,2-naphthochinon-2-diazid-5-sulfonsäureester des 2,2-Bis-(4-hydroxyphenyl)-propans (Vergleichsverbindung V) wurde folgendermaßen bestimmt: Jeweils 2 g Naphthochinondiazid wurden in 50 g Äthylenglykolmonomethyläther suspendiert und 2 Stunden bei 26°C gerührt. Anschliessend saugte man das Gemisch ab, wusch den Filterrückstand nacheinander mit 10 $cm^3$ Methanol und 10 $cm^3$ Äther, trocknete ihn im Vakuum und bestimmte sein Gewicht. Aus der Differenz zur eingesetzten Menge werden die in Tabelle 2 angeführten Löslichkeiten in Äthylenglykolmonomethyläther errechnet:

TABELLE 2

| Löslichkeit verschiedener Naphthochinondiazide | |
|---|---|
| Verbindung Nr. | Löslichkeit (%) |
| 2 | 1,85 |
| 3 | 0,86 |
| 7 | 0,91 |
| 8 | 3,80 |
| 9 | 1,54 |
| 19 | 0,95 |
| 20 | >7,4 |
| 22 | 6,0 |
| V | 0,75 |

Die Tabelle zeigt, daß die Löslichkeit der Verbindung V durch die neuen Verbindungen beträchtlich übertroffen wird. Die Verbindungen 2, 8, 9, 20 und 22 werden dabei aufgrund ihrer sehr guten Löslichkeit besonders bevorzugt. In allen Fällen wurde durch Beugungsdiagramme im Röntgendiffraktometer sichergestellt, daß die untersuchten Proben im wesentlichen frei von amorphen Anteilen waren. In jedem Falle ist die Löslichkeit einer ganz oder teilweise im amorphen Zustand vorliegenden festen Verbindung deutlich höher als die der entsprechenden kristallinen Verbindung. Ein Vergleich mit diesen Werten ist aber nicht zuverlässig, da die Löslichkeiten von amorphen Verbindungen wegen der unterschiedlichen Kristallisationsneigung übersättigter Lösungen nicht genau reproduzierbar ermittelt werden können.

Beispiel 1

Eine elektrolytisch aufgerauhte und anodisierte Aluminiumfolie wird mit einer Beschichtungslösung, bestehend aus

| | | |
|---|---|---|
| 6,3 | Gt | Kresol-Formaldehyd-Novolak (Schmelzbereich 105—120°C nach DIN 53 181), |
| 1,2 | Gt | Verbindung 3, |
| 0,07 | Gt | Kristallviolett-Base, |
| 0,17 | Gt | 1,2-Naphthochinon-2-diazid-4-sulfochlorid, |
| 0,25 | Gt | Maleinatharz (Schmelzbereich 135—145°C, Säurezahl 15—25) und |
| 92,01 | Gt | eines Lösungsmittelgemisches aus Tetrahydrofuran, Äthylenglykolmonomethyläther und Butylacetat im Gew.-Verhältnis von 2:2:1 |

schleuderbeschichtet, so daß sich nach dem Trocknen ein Schichtgewicht von 2,0 $g/m^2$ ergibt. Die beschichtete Druckplatte wird durch ein Diapositiv unter einer 5 kW-Metallhalogenidlampe im Abstand von 110 cm 50 Sekunden belichtet und mit dem Entwickler der folgenden Zusammensetzung

| | | |
|---|---|---|
| 5,5 | Gt | Natriummetasilikat x 9 $H_2O$, |
| 3,4 | Gt | Trinatriumphosphat x 12 $H_2O$, |
| 0,4 | Gt | Natriumhydrogenphosphat, wasserfrei und |
| 90,7 | Gt | Wasser |

entwickelt, wobei die belichteten Schichtbereiche entfernt werden. Ein Druckversuch mit einer so hergestellten Offsetdruckform wird nach 130 000 Drucken immer noch einwandfreier Qualität abgebrochen. Ein ähnliches Ergebnis wird erhalten, wenn die Verbindung 3 in obiger Rezeptur durch gleiche Mengen der Verbindungen 4, 5, 6, 7, 8, 11, 19, 20, 21 oder 22 ersetzt wird.

Beispiel 2

Die neuen Naphthochinondiazide mit freier Carboxylgruppe eignen sich sehr gut zur Herstellung von rasterlosen Flachdruckplatten. Zu diesem Zweck wird mit einer Lösung von

13,6 Gt Verbindung 1,
68,0 Gt Novolak nach Beispiel 1,
17,0 Gt eines Vinylacetat-Crotonsäure-Mischpolymerisats (95:5) vom Molekulargewicht 100 000 und
1,4 Gt Sudanblau II (C.I. Solvent Blue 35)

in 1000 Gt eines Äthylenglykolmonoäthyläther/Butylacetat-Gemischs im Verhältnis 8:2 eine mechanisch aufgerauhte Aluminiumfolie beschichtet. Nach der Trocknung wird die Schicht unter einer positiven Halbtonvorlage, die 13 gleiche Dichtestufen von 0,15 bis 1,95 aufweist, mit dem im Beispiel 1 beschriebenen Gerät 90 Sekunden belichtet und in einer Minute mit dem Entwickler aus Beispiel 1 entwickelt. Man erhält ein Druckbild für den rasterlosen Offsetdruck mit sehr weichen Tonwertübergängen und 11 Keilstufen. Mit ähnlichem Ergebnis ist die Verbindung 1 in obiger Rezeptur durch gleiche Gewichtsmengen der Verbindung 12 zu ersetzen.

Beispiel 3

Farbprüffolien für die Mehrfarben-Offsetkopie werden hergestellt, indem man mit einer Lösung von

27,1 Gt Novolak nach Beispiel 1,
6,8 Gt Vinylacetat-Crotonsäure-Mischpolymerisat nach Beispiel 2,
18,6 Gt Verbindung 9 oder 15,
13,6 Gt Polyäthylacrylat-Lösung (40% in Toluol, Plexisol B 574, Fa. Röhm),
23,7 Gt Polyvinyläthyläther, niedrigviskos, und
10,2 Gt Gelbfarbstoff Auramin O (C.I. 41 000)

in Äthylenglykolmonoäthyläther eine Polyesterfolie von 100 µm Dicke beschichtet, so daß die Schichtstärke nach dem Trocknen 1 µm beträgt. Statt des Gelbfarbstoffes werden für die entsprechenden Blau- bzw. Rotfarbfolien gleiche Mengen der Farbstoffe

Viktoriareinblau FGA (C.I. Basic Blue 81) bzw.
Grasolechtrubin 2 BL (C.I. Solvent Red 128)

verwendet.

Nach dem Belichten unter positiven Vorlagen, d. h. den entsprechenden Farbauszügen für einen Mehrfarbendruck, und Entwicklung in dem 1:1 mit Wasser verdünnten Entwickler aus Beispiel 1 erhält man farbige Kopien der verwendeten Vorlagen.

Beispiel 4

Zur Herstellung eines Positiv-Trockenresists werden

11,15 Gt Novolak nach Beispiel 1,
2,79 Gt Vinylacetat-Crotonsäure-Mischpolymerisat nach Beispiel 2,
4,18 Gt eines Mischpolymerisats aus 5:1:2 Teilen n-Hexylmethacrylat/Methylmethacrylat/Methacrylsäure mit der Säurezahl 158,
1,86 Gt Polyäthylenglykol, Molgewicht 2000,
2,79 Gt Epoxidharz mit dem Epoxyäquivalentgewicht 190,
2,32 Gt der Verbindung 9,
0,45 Gt 1,2-Naphthochinon-2-diazid-4-sulfochlorid und
0,06 Gt Kristallviolett in
46,50 Gt Äthylenglykolmonoäthyläther und
27,90 Gt Methyläthylketon

gelöst. Damit wird eine ca. 25 µm dicke, mit einer wäßrigen Lösung von 10% Trichloressigsäure, 1% Polyvinylalkohol und 0,1% Netzmittel vorbehandelte Polyesterfolie beschichtet und getrocknet. Auf die ca. 20 µm dicke Resistschicht wird dann eine Polyäthylen-Deckfolie zum Schutz gegen Staub und Verkratzungen aufgebracht.

Zur Herstellung von Leiterplatten wird die Positiv-Trockenresistfolie nach Abziehen der Deckfolie in einem handelsüblichen Laminator auf eine gereinigte ca. 35 $\mu$m dicke Kupferfolie laminiert, die auf einen Isolierstoffträger aufkaschiert ist. Nach Abziehen der Trägerfolie, evtl. Nachtrocknen, ca. 3 Minuten Belichten mit dem in Beispiel 1 beschriebenen Gerät und ca. 2 Minuten Sprühentwickeln mit einem Entwickler der folgenden Zusammensetzung

0,6 Gt NaOH,
0,5 Gt $Na_2SiO_3 \times 5 H_2O$,
1,0 Gt n-Butanol und
97,9 Gt Wasser

erhält man eine ausgezeichnete bildmäßige Resistschicht. Sie widersteht nicht nur den Bedingungen von Ätzprozessen, z. B. mit $FeCl_3$, sondern ist auch galvano-resistent bei der Herstellung durchkontaktierter Schaltungen insbesondere bei dem galvanischen Aufbau von Kupfer, Nickel und Gold hintereinander.

Beispiel 5

Eine Lösung von

3,0 Gt der Verbindung 2 oder 8,
21,0 Gt Phenol-Formaldehyd-Novolak mit dem Schmelzbereich 110—120°C (nach Kapillar-Methode DIN 53 181),
3,0 Gt Vinylacetat-Crotonsäure-Mischpolymerisat nach Beispiel 2,
3,0 Gt Epoxidharz (Epoxyäquivalentgewicht um 450),
0,4 Gt des Farbstoffs Sudanblau II (C.I. Solvent Blue 35)
in
49,6 Gt Äthylenglykolmonoäthylätheracetat,
10,0 Gt Äthylenglykolmonoäthyläther und
10,0 Gt Butylacetat

ergibt einen Positiv-Kopierlack, der sich für die Fertigung von Leiterplatten, von Kupfertiefdruckzylindern, zur Anwendung beim Formteilätzen oder für Nickelgalvanoschalblonen eignet.

Beispiel 6

Auf mechanisch aufgerauhte Aluminiumfolie wird eine Kopierschicht der folgenden Zusammensetzung

86,6 Gt Kresol-Formaldehyd-Novolak nach Beispiel 1,
12,8 Gt Verbindung 13,
2,6 Gt 1,2-Naphthochinon-2-diazid-4-sulfochlorid und
1,0 Gt Kristallviolett

aufgebracht. Man erhält eine positiv arbeitende Offset-Druckplatte, die in üblicher Weise belichtet und entwickelt wird. Mit ähnlichem Ergebnis kann die Verbindung 13 durch gleiche Gewichtsmengen der Verbindung 14 oder 16 ersetzt werden. Beim Ersatz von 13 durch 10 resultiert eine etwas weichere Gradation.

**Patentansprüche**

1. Lichtempfindliches Gemisch, enthaltend ein wasserunlösliches im wäßrig-alkalischen Lösungen lösliches oder quellbares harzartiges Bindemittel und einen Bis-1,2-naphthochinon-2-diazidsulfonsäureester eines 4,4'-Dihydroxy-diphenylmethanderivats, dadurch gekennzeichnet, daß der Ester der Formel I

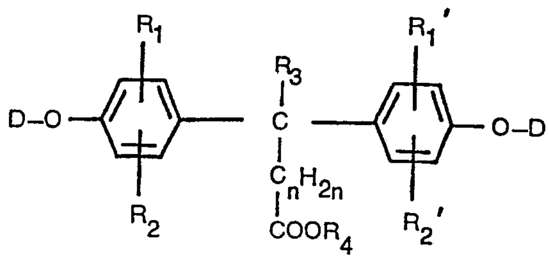

(I)

entspricht, worin

$R_1$, $R_1'$, $R_2$ und $R_2'$ gleich oder verschieden sind und Wasserstoff-, Chlor- oder Bromatome, Alkyl-,

Alkoxy- oder Alkoxyalkylreste mit 1 bis 6 Kohlenstoffatomen oder Alkenylreste mit 2 bis 6 Kohlenstoffatomen,

$R_3$ ein Wasserstoffatom oder einen Alkylrest mit 1 bis 4 Kohlenstoffatomen,

$R_4$ ein Wasserstoffatom, einen ggf. substituierten Alkylrest, dessen Kohlenstoffkette durch Äthersauerstoffatome unterbrochen sein kann, einen gegebenenfalls substituierten Cycloalkylrest mit 5 bis 16 Kohlenstoffatomen oder einen ggf. substituierten Alkenylrest mit 2 bis 16 Kohlenstoffatomen,

n Null oder eine ganze Zahl von 1 bis 4 und

D einen 1,2-Naphthochinon-2-diazid-sulfonylrest

bedeuten.

2. Lichtempfindliches Gemisch nach Anspruch 1, dadurch gekennzeichnet, daß es einen Ester der Formel I enthält, worin

$R_1$, $R_1'$, $R_2$ und $R_2'$ Wasserstoffatome oder Methylgruppen, die in 3- oder 3,5-Stellung der 4-Hydroxy-phenyl gruppen stehen,

$R_3$ eine Methylgruppe und

n eine ganze Zahl von 1 bis 3

bedeuten.

3. Lichtempfindliches Gemisch nach Anspruch 1, dadurch gekennzeichnet, daß es einen Ester der Formel I enthält, worin

$R_1$, $R_1'$, $R_2$ und $R_2'$ Wasserstoffatome oder Methylgruppen, die in 3- oder 3,5-Stellung der 4-Hydroxy-phenylgruppen stehen,

$R_3$ ein Wasserstoffatom und

n die Zahl 0

bedeuten.

4. Lichtempfindliches Gemisch nach Anspruch 1, dadurch gekennzeichnet, daß es einen Ester der Formel I enthält, worin D ein 1,2-Naphthochinon-2-diazid-5-sulfonylrest ist.

5. Lichtempfindliches Gemisch nach Anspruch 1, dadurch gekennzeichnet, daß das Bindemittel ein Phenolharz ist.

6. Lichtempfindliches Gemisch nach Anspruch 1, dadurch gekennzeichnet, daß es, bezogen auf seine nichtflüchtigen Bestandteile, 7 bis 35 Gew.-% an Ester der Formel I enthält.

7. Lichtempfindliches Gemisch nach Anspruch 1, dadurch gekennzeichnet, daß es einen Ester der Formel I enthält, worin $R_4$ eine Äthoxyäthoxygruppe bedeutet.

8. Lichtempfindliches Gemisch nach Anspruch 4, dadurch gekennzeichnet, daß es einen Ester der Formel I enthält, worin

$R_1$, $R_1'$, $R_2$ und $R_2'$ Wasserstoffatome,

$R_3$ die Methylgruppe,

n die Zahl 2 und

$R_4$ die Äthoxyäthoxygruppe

bedeuten.

9. Lichtempfindliches Gemisch nach Anspruch 4, dadurch gekennzeichnet, daß es einen Ester der Formel I enthält, worin

$R_1$, $R_1'$, $R_2$, $R_2'$ und $R_3$ Wasserstoffatome

n die Zahl Null und

$R_4$ die Äthoxyäthoxygruppe

bedeuten.

10. Lichtempfindliches Gemisch nach Anspruch 4, dadurch gekennzeichnet, daß es einen Ester der Formel I enthält, worin

$R_1$, $R_1'$, $R_2$, $R_2'$ und $R_3$ Wasserstoffatome,

n die Zahl Null und

$R_4$ die n-Butylgruppe

bedeuten.

## Claims

1. A light-sensitive mixture, containing a resinous binder, which is insoluble in water and soluble or swellable in aqueous-alkaline solutions, and a bis-1,2-naphthoquinone-2-diazide-sulfonic acid ester of a 4,4'-dihydroxy-diphenylmethane derivative, characterized in that the ester corresponds to the formula I

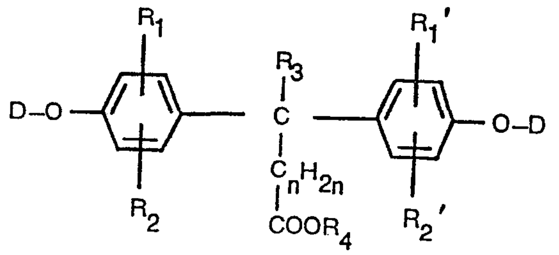

(I)

in which $R_1$, $R_1'$, $R_2$ and $R_2'$ are identical or different and represent hydrogen, chlorine or bromine atoms, alkyl, alkoxy or alkoxyalkyl groups having 1 to 6 carbon atoms or alkenyl groups having 2 to 6 carbon atoms, $R_3$ represents a hydrogen atom or an alkyl group having 1 to 4 carbon atoms, $R_4$ represents a hydrogen atom, a substituted or unsubstituted alkyl group, the carbon chain of which can be interrupted by ether oxygen atoms, a substituted or unsubstituted cycloalkyl group having 5 to 16 carbon atoms or a substituted or unsubstituted alkenyl group having 2 to 16 carbon atoms, n represents zero or an integer from 1 to 4 and D represents a 1,2-naphthoquinone-2-diazide-sulfonyl group.

2. A light-sensitive mixture as claimed in claim 1, characterized in that it contains an ester corresponding to formula I, in which $R_1$, $R_1'$, $R_2$ and $R_2'$ represent hydrogen atoms or methyl groups which are in the 3-position or 3,5-positions of the 4-hydroxy-phenyl groups, $R_3$ represents a methyl group, and n represents an integer from 1 to 3.

3. A light-sensitive mixture as claimed in claim 1, characterized in that it contains an ester corresponding to formula I, in which $R_1$, $R_1'$, $R_2$ and $R_2'$ represent hydrogen atoms or methyl groups which are in the 3-position or 3,5-positions of the 4-hydroxy-phenyl groups, $R_3$ represents a hydrogen atom, and n represents 0.

4. A light-sensitive mixture as claimed in claim 1, characterized in that it contains an ester corresponding to formula I, in which D is a 1,2-naphthoquinone-2-diazide-5-sulfonyl group.

5. A light-sensitive mixture as claimed in claim 1, characterized in that a phenolic resin is the binder.

6. A light-sensitive mixture as claimed in claim 1, characterized in that it comprises 7 to 35% by weight of an ester of formula I, relative to its non-volatile constituents.

7. A light-sensitive mixture as claimed in claim 1, characterized in that it contains an ester corresponding to formula I, in which $R_4$ represents an ethoxyethoxy group.

8. A light-sensitive mixture as claimed in claim 4, characterized in that it contains an ester corresponding to formula I, in which $R_1$, $R_1'$, $R_2$ and $R_2'$ represent hydrogen atoms, $R_3$ represents a methyl group, n represents the number 2, and $R_4$ represents an ethoxyethoxy group.

9. A light-sensitive mixture as claimed in claim 4, characterized in that it contains an ester corresponding to formula I, in which $R_1$, $R_1'$, $R_2$, $R_2'$ and $R_3$ represent hydrogen atoms, n represents the number zero and $R_4$ represents an ethoxyethoxy group.

10. A light-sensitive mixture as claimed in claim 4, characterized in that it contains an ester corresponding to formula I, in which $R_1$, $R_1'$, $R_2$, $R_2'$ and $R_3$ represent hydrogen atoms, n represents the number zero and $R_4$ represents an n-butyl group.

**Revendications**

1. Composition photosensible, contenant un liant résineux insoluble dans l'eau, soluble ou susceptible de gonfler dans des solutions aqueuses alcalines et un ester bis-1,2-naphtoquinone-2-diazide-sulfonique d'un dérivé de 4,4'-dihydroxy-diphénylméthane, caractérisé en ce que l'ester répond à la formule I

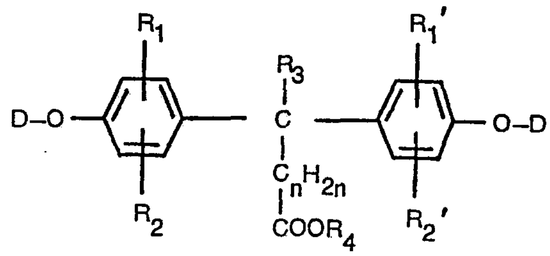

(I)

dans laquelle:

$R_1$, $R_1'$, $R_2$ et $R_2'$ sont identiques ou différents et sont des atomes d'hydrogène, de chlore ou de brome, des restes alkyle, alcoxy ou alcoxy-alkyle ayant de 1 à 6 atomes de carbone ou des restes alcényle ayant de 2 à 6 atomes de carbone,

$R_3$ est un atome d'hydrogène ou un reste alkyle ayant de 1 à 4 atomes de carbone,

$R_4$ est un atome d'hydrogène, un reste alkyle éventuellement substitué, dont la chaîne d'atomes de carbone peut être interrompue par des atomes d'oxygène du type éther, un reste cyclo-alkyle éventuellement substitué ayant de 5 à 16 atomes de carbone ou un reste alcényle éventuellement substitué ayant de 2 à 16 atomes de carbone,

n est égal à zéro ou à un nombre entier entre 1 et 4, et

D est un reste 1,2-naphtoquinone-2-diazide-sulfonyle.

2. Composition photosensible selon la revendication 1 caractérisée en ce qu'elle contient un ester de formule I dans laquelle:

$R_1$, $R_1'$, $R_2$ et $R_2'$ sont des atomes d'hydrogène ou des groupes méthyle se trouvant en position 3 ou en position 3,5 des groupes 4-hydroxy-phényle,

$R_3$ est un groupe méthyle et

n est un nombre entier de 1 à 3.

3. Composition photosensible selon la revendication 1 caractérisée en ce qu'elle contient un ester de formule I dans laquelle:

$R_1$, $R_1'$, $R_2$ et $R_2'$ sont des atomes d'hydrogène ou des groupes méthyle se trouvant en position 3 ou en position 3,5 des groupes 4-hydroxy-phényle,

$R_3$ est un atome d'hydrogène et

n est égal à zéro.

4. Composition photosensible selon la revendication 1 caractérisée en ce qu'elle contient un ester de formule I dans laquelle D est un reste 1,2-naphtoquinone-2-diazide-5-sulfonyle.

5. Composition photosensible selon la revendication 1 caractérisée en ce que le liant est une résine phénolique.

6. Composition photosensible selon la revendication 1 caractérisée en ce qu'elle contient par rapport à ses ingrédients non volatils entre 7 et 35% en poids d'un ester de formule I.

7. Composition photosensible selon la revendication 1 caractérisée en ce qu'elle contient un ester de formule I dans laquelle $R_4$ est un groupe éthoxy-éthoxy.

8. Composition photosensible selon la revendication 4, caractérisée en ce qu'elle contient un ester de formule I dans laquelle:

$R_1$, $R_1'$, $R_2$ et $R_2'$ sont des atomes d'hydrogène,

$R_3$ est le groupe méthyle

n est le nombre 2 et

$R_4$ est le groupe éthoxy-éthoxy.

9. Composition photosensible selon la revendication 4, caractérisée en ce qu'elle contient un ester de formule I dans laquelle:

$R_1$, $R_1'$, $R_2$, $R_2'$ et $R_3$ sont des atomes d'hydrogène

n est égal à zéro et

$R_4$ est le groupe éthoxy-éthoxy.

10. Composition photosensible selon la revendication 4 caractérisée en ce qu'elle contient un ester de formule I dans laquelle:

$R_1$, $R_1'$, $R_2$, $R_2'$ et $R_3$ sont des atomes d'hydrogène,

n est égal à zéro, et

$R_4$ est le groupe n-butyle.